# EUROPEAN PATENT APPLICATION

(11) **EP 1 575 166 A1**
(43) Date of publication of application: **14.09.2005**
(21) Application number: 03778933.6
(22) Date of filing: 15.12.2003
(51) Int. Cl.: H03H 9/215, H03H 9/19, H03H 9/10

(54) **PIEZOELECTRIC VIBRATION PIECE AND PIEZOELECTRIC DEVICE USING PIEZOELECTRIC VIBRATION PIECE, PORTABLE PHONE DEVICE USING IEZOELECTRIC DEVICE AND ELECTRONIC APPARATUS USING PIEZOELECTRIC DEVICE**

(30) Priority: 17.12.2002 JP 2002365531
(71) Applicant: SEIKO EPSON CORPORATION, Tokyo 163-0811 (JP)
(72) Inventor: Tanaya, Hideo, Suwa-Shi, Nagano 392-8502 (JP)
(74) Representative: Hoffmann, Eckart
(86) International application number: PCT/JP2003/016055
(87) International publication number: WO 2004/064252

(57) **Abstract**

To provide a piezoelectric vibration piece that is capable of appropriate vibration without increasing a Cl value by ensuring the strength along almost the entire length of a vibration arm with the movement of the vibration arm in the vertical direction suppressed, and a piezoelectric device using this piezoelectric vibration piece. Included are: a pair of vibration arms (34 and 35) that are formed by a piezoelectric material, and are extending in the horizontal direction from a base section (51); bottomed grooves (44 and 44) each provided to the vibration arms, and extending in the length direction of the corresponding vibration arm; and support sections (45 and 45) provided in such a manner as to across the groove in the width direction to integrally connect the material structuring the vibration arm separated by the groove in the width direction.

## Description

### Technical Field

The present invention relates to a piezoelectric vibration piece, a piezoelectric device comprising a package that accommodates the piezoelectric vibration piece, and a portable phone and electronic equipment using the piezoelectric device.

### Background Art

Piezoelectric devices such as piezoelectric vibrators and piezoelectric oscillators each accommodating a piezoelectric vibration piece in their package are widely applied to small-sized information equipment such as HDDs (Hard Disk Drive), mobile computers, or IC cards, and mobile communications devices such as portable phones, car phones, or paging systems.

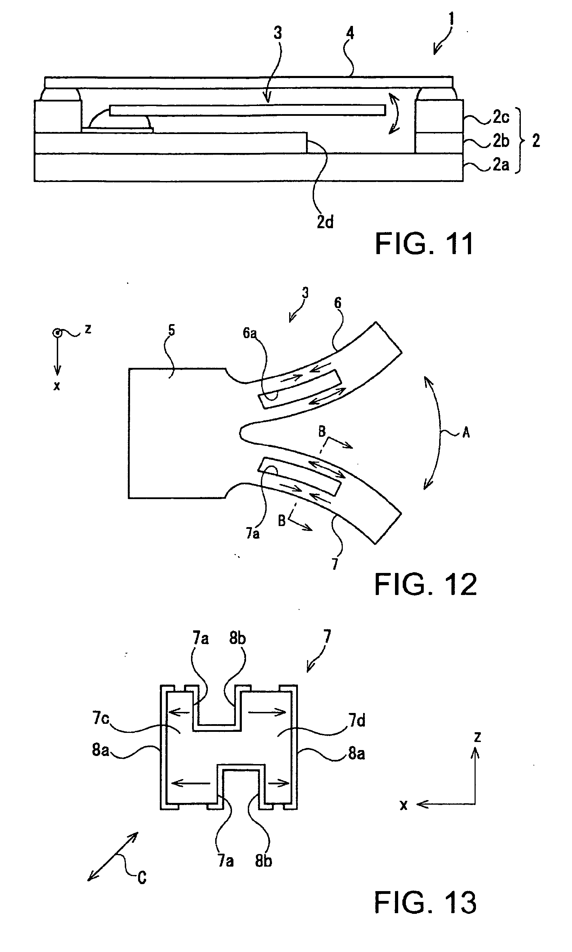

FIG. 11 is a schematic cross-sectional view showing an exemplary structure of such a piezoelectric device.

In the drawing, a piezoelectric device 1 accommodates a piezoelectric vibration piece 3 in its package 2. In this case, the package 2 is in the shape of a shallow box made of an insulation material, and the internally-accommodated piezoelectric vibration piece 3 is securely fixed therein before the package is sealed by a lid body 4.

The package 2 is formed by mold-laminating a plurality of substrates 2a, 2b, and 2c each being a ceramic green sheet before being subjected to sintering. Inside each of the substrates 2b and 2c, a hole is formed by eliminating the material at the time of substrate formation. Thereby, as shown in the drawing, a space is formed for accommodating the piezoelectric vibration piece 3.

The piezoelectric vibration piece 3 is exemplarily formed as shown in FIG. 12 by crystal etching. As shown in the drawing, the piezoelectric vibration piece 3 is structured by a, so-called, crystal flake of a tuning fork type including a base section 5, and a pair of vibration arms 6 and 7 horizontally extending from the base section 5 in the right direction in the drawing.

The vibration arms 6 and 7 are formed, respectively, with grooves 6a and 7a extending in the length direction. FIG. 13 shows the cross-sectional view of the vibration arm 7 cut along the line B-B. As shown in FIG. 13, excitation electrodes 8a and 8b are formed, and a driving voltage is applied from outside to these excitation electrodes 8a and 8b. As a result, as shown by arrows in FIG. 13, an electric field is established within the vibration arm 7 as shown by the arrows. By the action of such an electric field, with respect to the vibration arms 6 and 7 of FIG. 12, the material sandwiching the grooves 6a and 7a from both sides repeatedly expands and contracts as indicated by the arrows.

Thereby, as shown in FIG. 12, the vibration arms 6 and 7 so vibrate that the tip sides thereof come near or apart as shown by an arrow A. Note here that, in FIG. 12, the shown movement of the vibration arms 6 and 7 is extremely exaggerated, compared to the actual movement, for convenience of understanding. Extracting the vibration frequency of such vibration enables application to various signals exemplified by a control clock signal and the like.

Here, the vibration of the vibration arms 6 and 7 along the arrow A of FIG. 12 is the horizontal movement along the direction of arrow x of FIG. 13 (hereinafter, this direction is referred to as "horizontal direction").

[Patent Document 1] JP-A-56-65517
The issue here is that, in FIG. 13, in the manufacturing process of forming the grooves 7a and 7b in the front and back sides of the vibration arm 7, the grooves 7a and 7b are formed by half etching from the surface side and the back side of the vibration arm 7. To the vibration arm 7 having an arm width of only about 100 µm, the grooves 7a and 7b formed on the surface side and the back side as such are separately formed from the surface and back sides of the vibration arm 7. Thus, as shown in FIG. 13, in the drawing, they sometimes deviate from each other in the right and left directions, respectively.

In such a state, as shown in FIG. 12, when the vibration arms 6 and 7 vibrate in the direction of arrow A, the resulting movement includes the movement of a component in the z direction of FIG. 13 (in the below, this direction is referred to as "vertical direction"). The resulting vibration becomes one directed in the direction of arrow C.

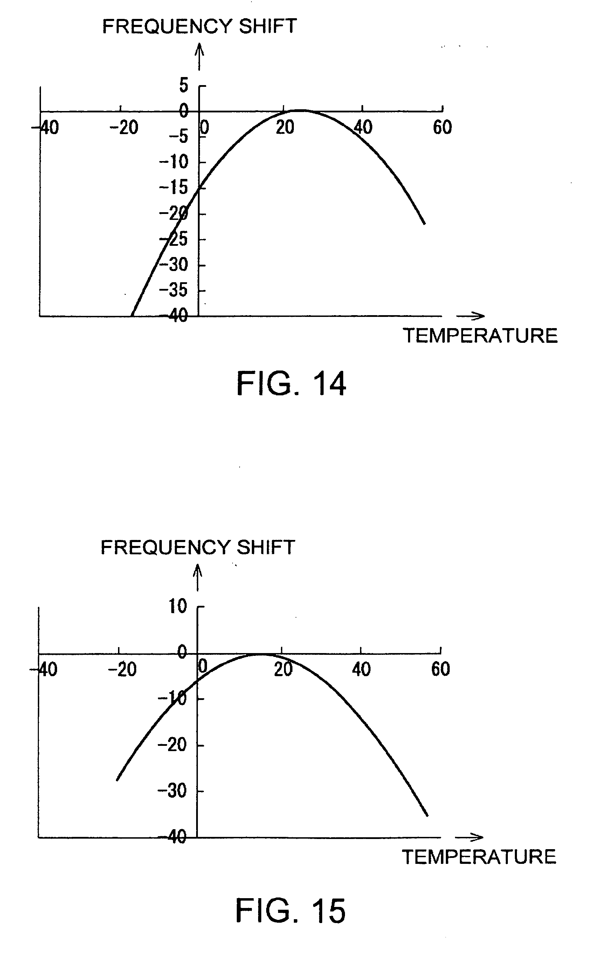

Such a vibration property change causes various harmful effects, and as examples, FIG. 14 shows the interrelation between the temperature change and the frequency shift of the piezoelectric vibration piece 3 when the vibration arms 6 and 7 vibrate correctly in the direction of arrow A, and FIG. 15 shows the interrelation between the temperature change and the frequency shift of the piezoelectric vibration piece 3 when the vibration arms 6 and 7 vibrate with the movement of the vertical component as described by referring to FIG. 13.

That is, the frequency f is expressed by the following equation, where k denotes a constant, E denotes an elastic constant, and I denotes a cross-sectional secondary moment.${\text{f = k·(E·I)}}^{\text{-2}}$

Therefore, the temperature property will look like a quadratic curve responding to the change of the elastic constant and the elastic secondary moment.

With a comparative study of the temperature property of such a piezoelectric vibration piece 3, in the case of FIG. 14, the maximum temperature with the frequency change is normal and in the close range of 25 degrees centigrade, and in the case of FIG. 15, the temperature is shifted to the negative side and about 14 degrees centigrade.

An object of the present invention is to provide a piezoelectric vibration piece achievable with appropriate vibration, a piezoelectric device utilizing the piezoelectric vibration piece by suppressing the movement of vibration arms in the vertical direction and by ensuring the strength along almost the entire length of the vibration arms, and a portable phone and electronic equipment using the piezoelectric device.

### Summary of the Invention

According to the first embodiment, the above-described object is achieved by a piezoelectric vibration piece that is including: a pair of vibration arms that are formed by a piezoelectric material, and are extending in the horizontal direction from a base section; a bottomed groove that is provided in each of the vibration arms, and extending in the length direction of the corresponding vibration arm; and a support section that is provided in such a manner as to cross the groove in the width direction to connect the material structuring the vibration arm separated by the groove in the width direction.

According to the structure of the first embodiment, the groove provided in each of the vibration arms is a bottomed groove. Thus, in comparison with the case of forming a through hole in each of the vibration arms, these vibration arms will have the better strength. Further, each of the grooves, is provided with the support section so formed as to cross the groove in the width direction to integrally connect the material structuring the vibration arm separated by the groove in the width direction. With such a structure, the support section becomes a unit, in structure, especially with the bottom section of the groove to support the material structuring the vibration arm separated by the groove in the width direction, thereby preventing twisting distortion from occurring. As a result, a better strength can be achieved in the twisting direction of the corresponding vibration arm.

According to the present invention, there is no longer need to provide plural support sections for each vibration arm. Thus, such effects as obtaining a piezoelectric vibration piece realizable with appropriate vibration can be exerted by ensuring the strength along almost the entire length of the vibration arm with the movement of the vibration arm suppressed in the vertical direction.

The second embodiment is characterized in that, in the structure of the first embodiment, a unit section being a unit with the bottom section of the groove of the support section is so formed as to be thicker than at least an end section locating on an opening side of the groove of the support section.

According to the structure of the second embodiment, the unit section, being a unit with the bottom section of the groove, of the support section is so formed as to be thicker than at least the end section locating on the opening side of the groove of this support section. In other words, the support section is formed in such a manner as to increase its thickness toward the bottom section of the groove. Therefore, the support section is securely connected especially to the bottom section of this groove. Accordingly, through such a secure fixation of the support section to the bottom section of this groove, in the piezoelectric vibration piece, the deformation force in the twisting direction of the vibration arms can be effectively dealt with. Thereby, the deformation in the twisting direction can be prevented from occurring in a more effective manner.

The third embodiment is characterized in that, in either structure of the first or second embodiment, the groove is provided on a surface side and a back side of each of the vibration arms.

According to the structure of the third embodiment, each of the vibration arms is formed with the groove on its surface and back sides. Thus, groove formation with a fine width in the narrow vibration arm sometimes results in a deviation of the groove position on the surface side from that on the back side. However, paying attention to the fact that such a bottomed groove exerts considerable effects in terms of strength enforcement of the vibration arms, inventors of the present invention are accepting such a process drawback as groove deviation between the surface and back sides, and if any harmful effects are caused thereby, they are solving those by forming the support section to each of the grooves on both the surface side and the back side. That is, providing a groove with a bottom section together with forming the support section to each of the grooves on the surface and back sides can effectively suppress the movement of the vertical component of each of the vibration arms.

A fourth embodiment is characterized in that, in the structure of any one of the first to third embodiments, plural support sections are formed for each groove.

According to the structure of the fourth embodiment, a Cl (Crystal Impedance) value is increased as the number of the support sections formed to each groove is increased. By increasing the number of the support sections in such a way, the vibration arms can be improved in strength.

A fifth embodiment is characterized in that, in the structure of any one of the first to fourth embodiments, each of the vibration arms has an arm width in a range from 50 µm to 150µm, and the depth of the groove is 30% or more but less than 50% of the material thickness of each of the vibration arms.

According to the structure of the fifth embodiment, when the arm width of the respective vibration arms is in a range from 50 µm to 150 µm, assuming that the depth of the groove is less than 30% of the material thickness of each of the vibration arms, the reduction effects for the Cl value cannot be enough. Thereby the Cl value fails to be practical. Further, if the depth of the groove exceeds 50% of the material thickness of the respective vibration arms, groove formation to the surface and back sides of the corresponding vibration arm becomes impossible.

A sixth embodiment is characterized in that, in the structure of any one of the structures of the first to fifth embodiments, the groove width of the groove provided in each of the vibration arms is 40% or more of the arm width of the corresponding vibration arm.

According to the structure of the sixth embodiment, with 40% or more of the arm width of the vibration arm, achieved are such effects that the Cl value can be appropriately controlled, so that the practical Cl value can be realized.

A seventh embodiment is characterized in that, in the structure of the sixth embodiment, the groove width of the groove provided in each of the vibration arms is 70% or more of the arm width of the corresponding vibration arm.

According to the structure of the seventh embodiment, with 70% or more of the arm width of the vibration arm, the Cl value can be suppressed in the most effective manner, and with or close to 100% of the arm width of the vibration arm, groove formation to the vibration arm becomes impossible.

The above-described object is achieved by a piezoelectric device accommodating a piezoelectric vibration piece in its case or package, and the piezoelectric vibration piece includes: a pair of vibration arms extending in a horizontal direction from a base section; a bottomed groove that is provided in each of the vibration arms, and is extending along the length direction of each of the vibration arms; and a support section so provided as to cross the groove in the width direction to integrally connect, the material structuring the vibration arm separated by the groove in the width direction.

According to the eighth embodiment, in each of the vibration arms of the piezoelectric vibration piece accommodated in this piezoelectric device, a bottomed groove is formed. The support section provided to the groove is, especially, structured to be a unit with the bottom section of the groove to support the material structuring the vibration arm separated by the groove in the width direction. With such a structure, deformation is prevented from occurring. Thus, strength enforcement can be achieved in the twisting direction of each of the vibration arms. As such, with respect to the piezoelectric vibration piece accommodated in the piezoelectric device, the strength is ensured along almost the entire length of the vibration arm with the movement of the vibration arms suppressed in the vertical direction, thereby realizing appropriate vibration.

The above-described object is achieved, according to a ninth embodiment, by a portable phone unit utilizing a piezoelectric device that is accommodating a piezoelectric vibration piece in its case or package, and a clock signal is derived for control by the piezoelectric device in which the piezoelectric vibration piece includes: a pair of vibration arms extending in a horizontal direction from a base section; a bottomed groove that is provided in each of the vibration arms, and is extending along the length direction of each of the vibration arms; and a support section so provided as to cross the groove in the width direction to integrally connect the material structuring the vibration arm separated by the groove in the width direction.

The above-described object is achieved by, according to a tenth embodiment, electronic equipment utilizing a piezoelectric device that is accommodating a piezoelectric vibration piece in its case or package, and a clock signal is derived for control by the piezoelectric device in which the piezoelectric vibration piece includes: a pair of vibration arms extending in a horizontal direction from a base section; a bottomed groove that is provided in each of the vibration arms, and is extending along the length direction of each of the vibration arms; and a support section so provided as to cross the groove in the width direction to integrally connect the material structuring the vibration arm separated by the groove in the width direction.

### Brief Description of the Drawings

FIG. 1 is a schematic plan view showing an embodiment of a piezoelectric device of the present invention.
FIG. 2 is a schematic cross-sectional view cut along line E-E of FIG. 1.
FIG. 3 is a schematic perspective view showing the main section of a piezoelectric vibration piece to be used for the piezoelectric device of FIG. 1.
FIG. 4 is a cross-sectional view cut along line F-F of FIG. 3.
FIG. 5 is a graph showing the relationship between a frequency change ratio and a current based on an electrical field formed, at the time of driving, in the piezoelectric vibration piece whose vibration arm has no groove.
FIG. 6 is a graph showing the relationship between a frequency change ratio and a current based on an electrical field formed, at the time of driving, in the piezoelectric vibration piece whose vibration arm has a groove but no support section.
FIG. 7 is a graph showing the relationship between a frequency change ratio and a current based on an electrical field formed, at the time of driving, in the piezoelectric vibration piece of the present embodiment.
FIG. 8 is a graph showing the interrelation between a Cl value and a temperature property as to the piezoelectric vibration piece of a so-called tuning fork type whose vibration arm has a groove but no support section.
FIG. 9 is a graph showing the interrelation between a Cl value and a temperature property as to the piezoelectric vibration piece of the present embodiment.
FIG. 10 is a diagram showing the schematic structure of a portable digital phone unit as exemplary electrical equipment utilizing the piezoelectric device according to the embodiment of the present invention.
FIG. 11 is a schematic cross-sectional view showing an exemplary conventional piezoelectric device.
FIG. 12 is a schematic plan view of a piezoelectric vibration piece to be used for the piezoelectric device of FIG. 11.
FIG. 13 is a cross-sectional view cut along line B-B of FIG. 12.
FIG. 14 is a graph showing the normal relationship between the frequency shift and the temperature property as to the piezoelectric vibration piece to be used for the piezoelectric device of FIG. 11.
FIG. 15 is a graph showing the fact that the unfavorable relationship is observed between the frequency shift and the temperature property as to the piezoelectric vibration piece to be used for the piezoelectric device of FIG. 11.

### Best Mode for Carrying Out the Invention

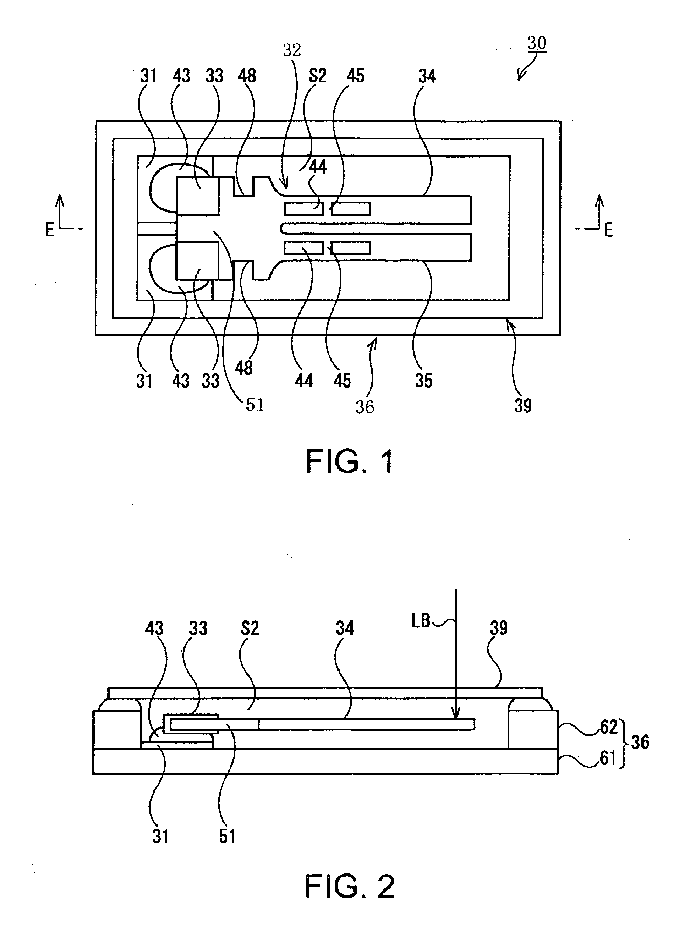

FIGS. 1 and 2 both show a first embodiment of a piezoelectric device of the present invention. FIG. 1 is a schematic plan view thereof, and FIG. 2 is a schematic cross-sectional view cut along line E-E of FIG. 1.

In the drawings, a piezoelectric device 30 is exemplarily structuring a piezoelectric vibrator, and the piezoelectric device 30 is accommodating a piezoelectric vibration piece 32 in its package 36. As an insulating material, the package 36 is formed, for example, by mold-laminating a plurality of substrates each being a ceramic green sheet made of aluminum oxide before being subjected to sintering. Inside of each of the substrates is formed a predetermined hole. Thus, after being laminated, a predetermined inner space S2 is formed inside. In this embodiment, for the purpose of minimizing the thickness of the package 36, a first substrate 61 and a second substrate 62 are laminated together. By eliminating the material inside of the second substrate 62, the inner space S2 is formed.

This inner space S2 is an accommodating space for accommodating the piezoelectric vibration piece.

In the drawing showing the inner space S2 of the package 36, in the vicinity of the left end section, provided, to the first substrate 61 structuring the inner bottom section exposed to the inner space S2, are electrode sections 31 and 31 formed by nickel plating or gold plating on tungsten metallization.

These electrode sections 31 and 31 are connected to the outside, and provided for supplying a driving voltage. Coated on the respective electrode sections 31 and 31 is conductive adhesive 43 and 43. On the conductive adhesive 43 and 43, mounted are extraction electrodes 33 and 33 provided to both end sections, in the width direction, of the base section 51 of the piezoelectric vibration piece 32. Then, the conductive adhesive 43 and 43 is hardened. Herein, as the conductive adhesive 43 and 43, used is a mixture resulting from mixing conductive particles such as fine silver particles with synthetic resin as an adhesive component exerting coupling force, and a possibility therefor is silicone, epoxy, or polyimide conductive adhesive and the like, for example.

The piezoelectric vibration piece 32 is formed by crystal, for example, and other than that, used therefor is a piezoelectric material such as tantalic acid lithium, or lithium niobate. In the present embodiment, the piezoelectric vibration piece 32 is shaped especially as shown in the figure to obtain the necessary performance even it forms small. That is, the piezoelectric vibration piece 32 includes the base section 51 fixed to the side of the package 36 in a manner described later. Also included are a pair of vibration arms 34 and 35 being bifurcated and extending parallel from this base section 51 to the right direction in the drawing. Hence, used is a so-called tuning-fork type piezoelectric vibration piece which has a shape like a tuning-fork as a whole.

The detailed structure of this piezoelectric vibration piece 32 will be described later in more detail.

To an opening upper end of the package 36, a lid body 39 is coupled for sealing. The lid body 39 is formed by a light-transmissive material, specifically, a thin-plate glass to allow, after being sealingly fixed to the package 36, frequency adjustment by the mass reduction process by externally applying laser light LB to a metal-coated part of the piezoelectric vibration piece 32 or a part of the excitation electrode (not shown), as shown in FIG. 2.

Used as a glass material suited for the lid body 39 is, for example, a thin-plate glass manufactured by the downdraw process, for example, a borosilicate glass.

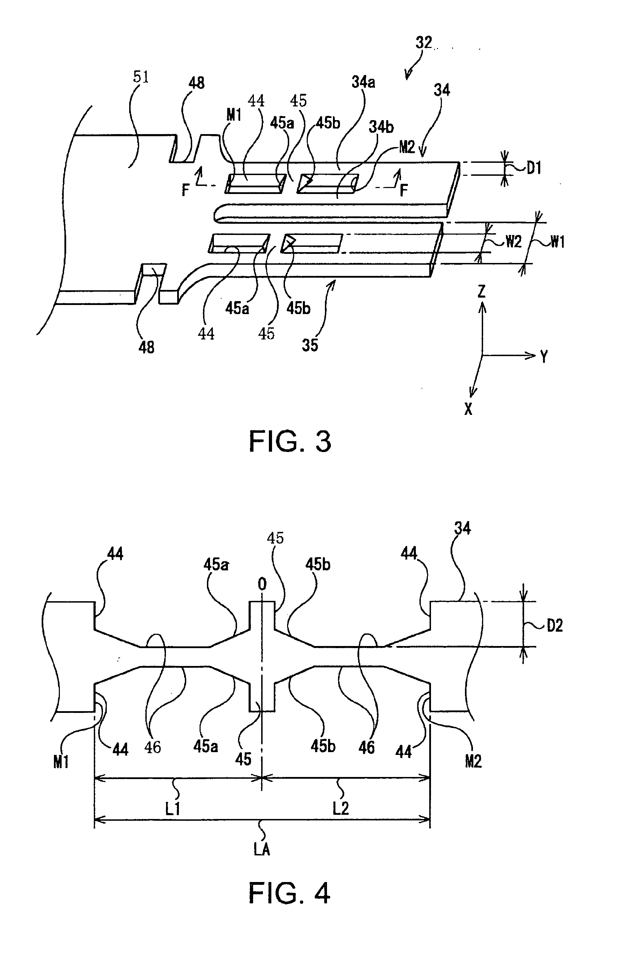

By referring now to FIGS. 3 and 4, described in detail is the piezoelectric vibration piece 32 to be accommodated in the package 36 of the piezoelectric device 30.

FIG. 3 is a schematic perspective view showing the structure of the piezoelectric vibration piece 32, and FIG. 4 is a cross-sectional view cut along line F-F of FIG. 3 (a diagram showing only the cross-sectional plane).

In FIG. 3, the piezoelectric vibration piece 32 is formed by processing crystal being a piezoelectric material to become a tuning-fork type. In this case, cutting from a single crystal is done in such a manner that the X axis of FIG. 3 will be an electrical axis, the Y axis will be a mechanical axis, and the Z axis will be an optical axis. At the time such cutting is done from the single crystal, in the orthogonal coordinates system structured by the above-described X, Y and Z axes, an XY plane structured by the X and Y axes is formed by tilting about -5 to +5 degrees in a counterclockwise direction about the X axis.

In FIG. 3, under such a condition, the piezoelectric vibration piece 32 is provided with a pair of vibration arms 34 and 35 horizontally extending from the base section 51 as described in the foregoing. In the present embodiment, the base section 51 of the piezoelectric vibration piece 32 includes, in the vicinity of the base end sections of the vibration arms 34 and 35, constriction sections or notch sections 48 and 48 formed by increasing or reducing the width of the base section 51. By including such notch sections 48 and 48, in the piezoelectric vibration piece 32, no vibration is transferred from the vibration arms 34 and 35 to the side of the base section 51.

The vibration arms 34 and 35 are provided with grooves 44 and 44, respectively, extending in the length direction. These grooves 44 and 44 are, as shown in FIG. 4, formed on the surface and back sides of each vibration arm 34. Although not shown in FIG. 4, the grooves formed in the vibration arm 35 have the same structure. In FIG. 4, the total length from one end section M1 to the other end section M2 in the length direction of the groove 44 is denoted by LA.

Further, in the vicinity of the end sections in the width direction of the end section (left end section in FIG. 2) of the base section 51 of the piezoelectric vibration piece 32, as already described above, formed are the extraction electrodes 33 and 33 for connection with the electrode sections 31 and 31 of the package 36. The extraction electrodes 33 and 33 are both provided on the surface side and the back side of the base section 51 of the piezoelectric vibration piece 32. Such extraction electrodes 33 and 33 are connected to excitation electrodes, not shown, provided in the grooves 44 and 44 of the vibration arms 34 and 35. The manner of providing such excitation electrodes is the same as the conventional, and thus is not described.

Next, the structure of the grooves 44 and 44 provided in the vibration arms 34 and 35 is described. The grooves have the same structure in both vibration arms 34 and 35. Thus, any illustration is indicated in FIG. 3 and 4 shown, and the comprehensive relationship between the vibration arms and grooves is described, for example.

The arm width W1 of the piezoelectric vibration piece 32 is, for example, in the range from 50 µm to 150 µm. With respect to the thickness D1 of the vibration arm 34 of the piezoelectric vibration piece 32, the groove depth D2 of the groove 44 of FIG. 4 is so set as to be 30% or more but less than 50% of D1.

The groove width W2 of the groove 44 is, preferably, so set as to be 40% or more of the arm width W1 of the vibration arm 35, and more preferably, 70% or more.

Moreover, as shown in FIG. 3, the material structuring the vibration arm 34 (in this embodiment, "crystal material") is separated into two parts of 34a and 34b by the groove 44 provided in the vibration arm 34. As shown in FIG. 4, the bottom section 46 is formed to be a unit with arm 34. Thus, the groove 44 is a bottomed groove, and not going through.

Furthermore, as shown in FIG. 3, the grooves 44 and 44 of the vibration arms 34 and 35 are provided, respectively, with support sections 45 and 45 both of a sidebar type, for example. To be specific, to the parts 34a and 34b formed as a result of separation by the groove 44 of the vibration arm 34, the support section 45 is connected to be a unit therewith.

As shown in FIG. 4, the support section 45 is formed to be a unit with the bottom section 46 of the groove 44, and the resulting unit sections 45a and 45b both being a unit with the groove bottom section 46 of the support section 45 are so formed as to be thicker than the thickness of the support section 45. Specifically, the unit section 45a where the support section 45 and the bottom section 46 are united together to be a piece is extending towards the bottom section 46, looking like a bell-bottom.

In this embodiment, as shown in FIG. 4, the groove 44 and the support section 45 have a one-to-one relationship, and the distance L1 from one end section M1 of the groove 44 to the center O of the support section 45 is equal to the distance L2 from the center O of the support section 45 to the other end section M2 of the groove 44.

With such a structure, the total length LA of the groove 44 is divided into two by the support section 45, and when the piezoelectric vibration piece 32 is driven, the bending vibration is equally divided by the support section 45. Thus, deformation in the twisting direction is cancelled out, preventing twisting deformation as a whole.

Further, there may be plural support sections 45 within the range of the total length LA of the groove 44. Thereby, the vibration arm 34 is increased in strength, and the Cl (Crystal Impedance) value is also increased. Accordingly, in the allowance range for increase of the Cl value, by increasing the number of the support sections 45, the strength of the vibration arm 34 can be increased to a greater degree.

The present embodiment is structured as above, and as shown in FIG. 4, the grooves 44 and 44 formed in the vibration arms 34 and 35, respectively, of the piezoelectric vibration piece 32 are both bottomed grooves. Thus, in comparison with a case of forming a through groove in both vibration arms 34 and 35, these vibration arms 34 and 35 are provided with the better strength.

Furthermore, in FIGS. 3 and 4, the grooves 44 are each provided with the support section 45. Forming a unit with the bottom section 46 of the groove 44, the support section 45 supports the parts 34a and 34b structuring the vibration arm 34 separated by the groove 44 in the width direction so that deformation in the twisting direction is prevented from occurring. Accordingly, the vibration arm 34 can be enforced in strength in the twisting direction thereof.

Hence, with the piezoelectric vibration piece 32, there is no need to provide plural support sections 45 to the groove 44 of the vibration arm 34 or 35. Thus, the Cl value is not increased, appropriate vibration can be realized by ensuring the strength along almost the entire length of the vibration arms with the movement of the vibration arms 34 and 35 suppressed in the vertical direction.

Further, as described by referring to FIG. 4, the support section 45 includes the unit sections 45a and 45b being thinner towards the bottom section 46 of the groove 44. Thus, the support section 45 is securely connected especially to the bottom section 46 of the groove 44. Accordingly, in the piezoelectric vibration piece 32, with the support section 45 being securely fixed to the bottom section 46 of the groove 44, the deformation force in the twisting direction of the vibration arm 34 is effectively dealt with. In such a manner, the deformation in the twisting direction can be prevented in a more effective manner.

Further, as already described in the foregoing, the arm width W1 of the vibration arms 34 and 35 of the piezoelectric vibration piece 32 is, for example, in the range from 50 µm to 150 µm. The groove depth D2 of the groove 44 is so set as to be 30% or more but less than 50% of the material thickness of the vibration arms 34 and 35. With such a structure, the Cl value can be low enough.

In this case, if the depth D2 of the groove 44 is less than 30% of the material thickness D1 of the vibration arm 34, the advantage of reduction of the Cl value cannot be sufficiently obtained, and sometimes the Cl value cannot be practical. With an exemplary tuning-fork vibrator of 32.768 kHz having an arm width of 100 µm, the Cl value is about 100 kΩ being close to the limit of the practical range even if the groove depth is 30 µm (30% of the material thickness), and the groove width is 70µm (70% of the arm width, and with this dimension, the Cl value is not reduced that much even if the groove width is widened more).

Moreover, when the depth D2 of the groove 44 exceeds 50% of the material thickness D1 of the vibration arm 34, it becomes impossible to form the groove 44 to the surface and back sides of the vibration arm.

As shown in FIG. 3, the groove width W2 of the groove 44 of the piezoelectric vibration piece 32 is so set as to be 40% or more of the arm width W1 of the vibration arm. In this case, if the groove width W2 of the groove 44 is less than 40% of the arm width W1 of the vibration arm, the advantage of reduction of the Cl value cannot be sufficiently obtained, and thus the resulting Cl value cannot be practical. With an exemplary tuning-fork vibrator of 32.768 kHz having an arm width of 100 µm, the Cl value is about 100 kΩ being close to the limit of the practical range even if the groove depth is 45 µm (45% of the material thickness, and increasing the groove depth more may go through the material, and is difficult to manufacture), and the groove width is 40µm (40% of the arm width).

Further, preferably, in the piezoelectric vibration piece 32, the groove width W2 of the groove 44 can be 70% or more of the arm width W1 of the vibration arm. In this manner, the Cl value will be in the range of maximizing the reduction effects thereof. Here, if the groove width W2 of the groove 44 is 100% of the arm width W1 of the vibration arm, needless to say, this does not allow groove formation.

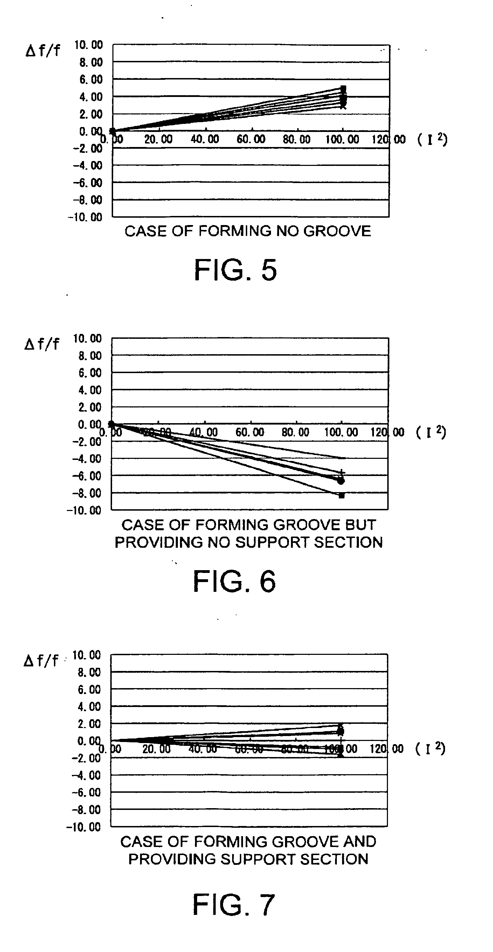

FIGS. 5 and 7 are both graphs as a result of simulation of the relationship between the frequency change rate and the current based on the electric field applied to the piezoelectric vibration piece at the time of driving.

With the piezoelectric vibration piece of a so-called tuning-fork type, assuming that Δf/f denotes a frequency change rate, and I² denotes a square value of the current flowing to the piezoelectric vibration piece, generally, the following relationship is established.${\text{Δf/f = k1·I}}^{\text{2}} {\text{+ k2·I}}^{\text{2}}$

Herein, k1 is a constant (becomes a positive value) that can be decided as an elastic body when the piezoelectric vibration piece vibrates in the horizontal direction. k2 is a constant (becomes a negative value) determined as an elastic body when the piezoelectric vibration piece vibrates in the vertical direction (z direction of FIG. 13).

FIG. 5 shows the property of the piezoelectric vibration piece of a case where no groove is formed in the piezoelectric vibration piece, that is, for example, the grooves 44 and 44 are not provided to such a piezoelectric vibration piece 32 as shown in FIG. 3. In such a case, Δf/f denotes a positive value, and the vibration frequency varies in the range from 3 to 5 ppm.

FIG. 6 shows the property of the piezoelectric vibration piece of a case where the piezoelectric vibration piece is formed only with a groove, that is, the piezoelectric vibration piece 32 of FIG. 3 is provided with the grooves 44 and 44 but not with the support sections 45 and 45, for example. In such a case, due to the reasons described by referring to FIG. 13, the vertical vibration component expressed by k2 becomes larger, Δf/f indicates a negative value, and the vibration frequency varies in the range from -8 to -4 ppm.

FIG. 7 shows the property of the piezoelectric vibration piece 32 of the present embodiment, that is, of the piezoelectric vibration piece in which the vibration arms 34 and 35 are formed with the grooves 44 and 44, and the support section 45 is formed in the groove 44. As shown in the drawing, compared with FIG. 6, it is understood that the vertical vibration component expressed by k2 is considerably reduced, and the variation ratio of the vibration frequency being Δf/f fits in the range from about -1 to +2.

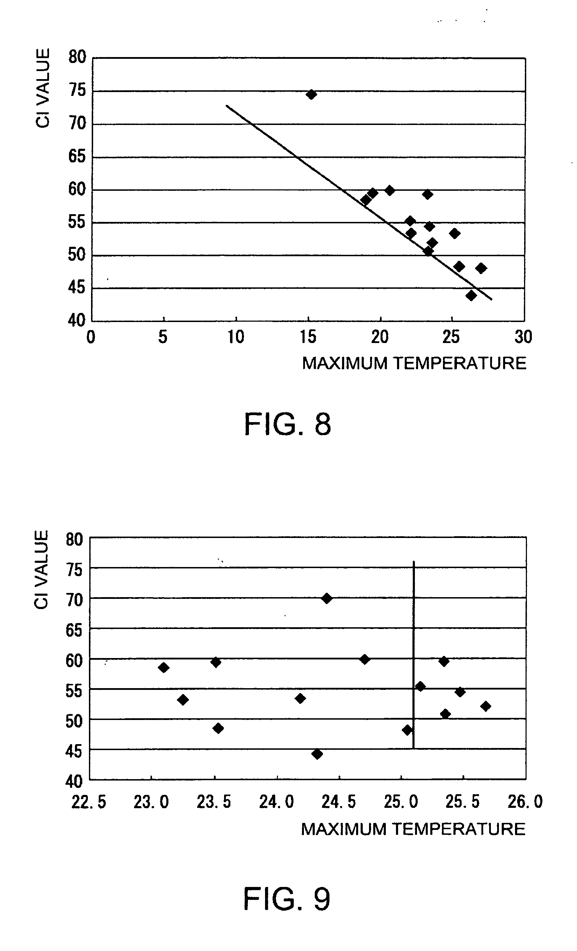

FIGS. 8 and 9 are both graphs showing the interrelation between the Cl value and the temperature property for the piezoelectric vibration piece of a so-called tuning-fork type, and shows the relationship between the change of the Cl value and the maximum temperature described by referring to FIGS. 14 and 15.

FIG. 8 is a graph showing the Cl value - temperature property of a case where the vibration arm is formed with a groove but not with a support section, and FIG. 9 is a graph showing the Cl value - temperature property of the piezoelectric vibration piece 32 of the present embodiment.

In the case of FIG. 8, as the Cl value changes (increases), the maximum temperature shifts toward the negative side. On the other hand, in the case of the present embodiment of FIG. 9, the maximum temperature does not shift even if the Cl value changes.

That is, as to FIG. 8, the reason why the interrelation is observed between the Cl value and the maximum temperature is that, when the vibration arm is formed with a groove but not with a support section, the vertical vibration component of the vibration arm becomes unstable. As shown in FIG. 9, if the vibration arm is formed with both a groove and a support section, the maximum temperature can be stable without depending on the Cl value as shown in FIG. 9.

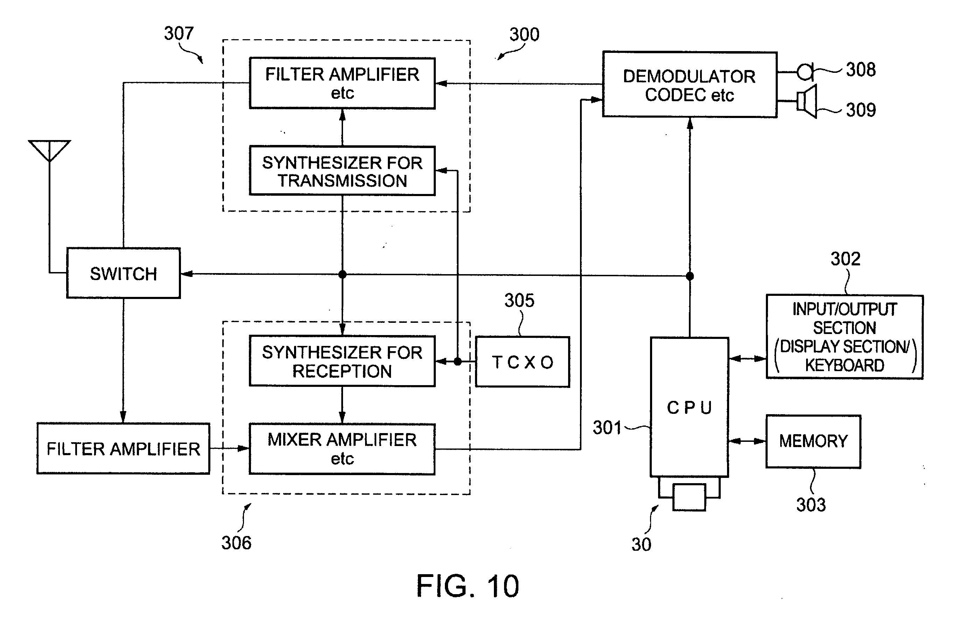

FIG. 10 is a diagram showing the schematic structure of a portable digital phone unit as an example of the electric equipment using the piezoelectric device according to the above-described embodiment of the present invention.

In the drawing, included are a microphone 308 for receiving the voice of a caller, and a speaker 309 for converting the received content into a voice output. Further, a CPU (Central Processing Unit) 301 being an integrated circuit as a control section connected to a modulation and demodulation section for a transmission and reception signal is also included.

Other than modulation and demodulation of a transmission and reception signal, the CPU 301 controls an information input/output section 302 structured by an LCD as an image display section, and operation keys and others for information input, and information storage means 303 structured by RAM, ROM, and others. Thus, to the CPU 301, the piezoelectric device 30 is connected, and the output frequency thereof is used as a clock signal matching the control details by a predetermined frequency divider (not shown) included in the CPU 301. The piezoelectric device 30 attached to the CPU 301 is not necessarily a single unit such as the piezoelectric device 30, but may be an oscillator as a result of combining the piezoelectric device 30 and the like, and any predetermined frequency divider and the like.

Further, the CPU 301 is connected to a temperature-compensated crystal oscillator (TCXO) 305, and the temperature-compensated crystal oscillator 305 is connected to both a transmission section 307 and a reception section 306. With such a structure, even if a basic clock from the CPU 301 varies responding to the change of the environment temperature, it is corrected by the temperature-compensated crystal oscillator 305 for supply to the transmission section 307 and the reception section 306.

By using the piezoelectric vibration piece 32 and the piezoelectric device 30 using the same according to the present embodiment described above for a an electric equipment such as a portable digital phone unit 300 including a control section, appropriate vibration can be realized without increasing the Cl value by ensuring the strength along almost the entire length of the vibration arm with the movement of the vibration arm in the vertical direction suppressed. Thereby, a correct clock signal can be generated.

The present invention is not restricted to the above embodiments. Each structure of the embodiments can be combined together or omitted as appropriate, or combined with any other structures that are not shown.

Further, this invention is applicable to every piezoelectric device no matter what name they carry such as a piezoelectric vibrator, a piezoelectric oscillator, or the like as long as a piezoelectric vibration piece is accommodated in a package, or a metal tubular case.

Still further, in the above embodiment, the package is in the shape of box made of a piezoelectric material. This is not restrictive, and the present invention is applicable to the ones including any type of package or case as long as the package is partially light transmittable.

The full disclosure text of Japanese Patent filed on December 17, 2002, with the application number 2002-365531 incorporated by reference in this Specification.

## Claims

1. A piezoelectric vibration piece, **characterized by** comprising:
a pair of vibration arms that are formed by a piezoelectric material, and are extending in a horizontal direction from a base section;
a bottomed groove provided in each of the vibration arms, and extending in a length direction of the corresponding vibration arm; and
a support section provided in such a manner as to cross the groove in a width direction to integrally connect the material structuring the vibration arm separated by the groove in the width direction.

2. The piezoelectric vibration piece according to Claim 1, **characterized in that** a unit section of the support section that is integrally connected with the bottom section of the groove is formed to be thinner than at least an end section locating on an opening side of the groove of the support section.

3. The piezoelectric vibration piece according to Claim 1 or 2, **characterized in that** a groove is provided on a surface side and a back side of each of the vibration arms.

4. The piezoelectric vibration piece according to any one of Claims 1 to 3, **characterized in that** plural support sections are formed for each groove.

5. The piezoelectric vibration piece according to any one of Claims 1 to 4, **characterized in that** each of the vibration arms has an arm width in the range from 50 µm to 150µm, and the depth of the groove is 30% or more but less than 50% of the material thickness of each of the vibration arms.

6. The piezoelectric vibration piece according to any one of Claims 1 to 5, **characterized in that** the groove width of the groove provided in each of the vibration arms is 40% or more of the arm width of the corresponding vibration arm.

7. The piezoelectric vibration piece according to Claims 6, **characterized in that** the groove width of the groove provided in each of the vibration arms is 70% or more of the arm width of the corresponding vibration arm.

8. A piezoelectric device accommodating a piezoelectric vibration piece in a case or a package, **characterized in that**
the piezoelectric vibration piece comprises:
a pair of vibration arms extending in a horizontal direction from a base section;
a bottomed groove that is provided in each of the vibration arms, and is extending along a length direction of the corresponding vibration arm; and
a support section provided so as to cross the groove in a width direction to integrally connect a material structuring the vibration arm separated by the groove in the width direction.

9. A portable phone unit utilizing a piezoelectric device that is accommodating a piezoelectric vibration piece in a case or a package, **characterized in that** a clock signal for control is derived by the piezoelectric device in which the piezoelectric vibration piece comprises:
a pair of vibration arms extending in a horizontal direction from a base section;
a bottomed groove that is provided in each of the vibration arms, and is extending along a length direction of the corresponding vibration arm; and
a support section provided so as to cross the groove in a width direction to integrally connect a material structuring the vibration arm separated by the groove in the width direction.

10. Electronic equipment utilizing a piezoelectric device that is accommodating a piezoelectric vibration piece in a case or a package, **characterized in that** a clock signal for control is derived by the piezoelectric device in which the piezoelectric vibration piece comprises:
a pair of vibration arms extending in a horizontal direction from a base section;
a bottomed groove that is provided in each of the vibration arms, and is extending along a length direction of the corresponding vibration arm; and
a support section provided so as to cross the groove in a width direction to integrally connect a material structuring the vibration arm separated by the groove in the width direction.
